# EUROPÄISCHE PATENTSCHRIFT

(11) **EP 0 582 216 B1**
(45) Veröffentlichungstag und Bekanntmachung des Hinweises auf die Patenterteilung: **05.11.1997**
(21) Anmeldenummer: 93112150.3
(22) Anmeldetag: 29.07.1993
(51) Int. Cl.: H01L 23/473

(54) **Flüssigkeitsgekühltes Stromrichtermodul mit Stromrichtermodulrahmen**
Liquid cooled rectifier module with rectifier module frame
Module redresseur refroidi par liquide avec un cadre de module redresseur

(30) Priorität: 04.08.1992 DE 4225675
(43) Veröffentlichungstag der Anmeldung: 09.02.1994
(73) Patentinhaber: ABB PATENT GmbH, 68309 Mannheim (DE)
(72) Erfinder: Krämer, Wilhelm, D-69207 Sandhausen (DE)
(74) Vertreter: Rupprecht, Klaus, Dipl.-Ing.

(56) Entgegenhaltungen:
- EP-A- 0 236 065
- DE-A- 2 640 646
- US-A- 4 381 032
- US-A- 4 864 385
- PATENT ABSTRACTS OF JAPAN vol. 8, no. 264 (E-282)(1701) 4. Dezember 1984 & JP-A-59 134 860 (HITACHI) 2. August 1984

## Beschreibung

Die Erfindung bezieht sich auf ein flüssigkeitsgekühltes Stromrichtermodul mit Stromrichtermodulrahmen gemäß dem Oberbegriff des Anspruchs 1.

Ein solches flüssigkeitsgekühltes Stromrichtermodul mit Stromrichtermodulrahmen ist aus der US-A-43 81 032 bekannt. Im bekannten Fall handelt es sich um eine Vorrichtung zur Kühlung integrierter Schaltkreise mit einer Grundplatte, in welcher der integrierte Schaltkreis montiert ist und mit einem Kühler, welcher auf der Grundplatte angeordnet ist und welcher mittels einer ihn durchströmenden Kühlflüssigkeit die während des Betriebes produzierte Verlustwärme abführt.

Ein weiteres flüssigkeitsgekühltes Stromrichtermodul mit Stromrichtermodulrahmen ist aus der DE 40 08 425 A1 bekannt. Dieses vorzugsweise mit Isolieröl gekühlte Stromrichtermodul besteht aus zwei metallenen Gehäusehälften und ist über Verschraubungen gas- und flüssigkeitsdicht zu einem vollgekapselten, allseitig geschlossenen Gehäuse verbunden. Eine Gehäusehälfte dient als Tragteil für alle Einbaukomponenten des Moduls, während die weitere Gehäusehälfte lediglich eine "Deckelfunktion" hat. Die Gate-Units zur Ansteuerung der GTO-Thyristoren sind außen am Stromrichtermodul befestigt. Bei diesem Modul wird die während des Betriebes entstehende Verlustleistungswärme über einen Ölkreislauf mit Umwälzpumpe aus dem Modul und dem Stromrichterschrank transportiert und mittels eines externen Rückkühlers an die Außenluft abgeführt. Das bekannte Stromrichtermodul eignet sich lediglich für eine elektrisch isolierende Kühlflüssigkeit. Soll eine elektrisch leitfähige Kühlflüssigkeit - vorzugsweise Brauchwasser mit einem Frostschutzmittel - verwendet werden, ist es beispielsweie möglich, die Verlustleistungswärme der Leistungsbauelemente des Moduls über elektrisch isolierende Kühldosen abzuführen, wobei die Kühldosen beispielsweise über Kunststoffschläuche und Schlauchbinder an den Kühlkreislauf anzuschließen sind. Kunststoffschläuche altern jedoch und Schlauchbinder können sich "setzen", wodurch die Gefahr von Defekten gegeben ist. Bei Wasserverlust infolge eines Lecks droht ein Totalausfall des Stromrichtermoduls mit der Folge eines hohen finanziellen Schadens.

Der Erfindung liegt die Aufgabe zugrunde, ein flüssigkeitsgekühltes Stromrichtermodul mit Stromrichtermodulrahmen der eingangs genannten Art mit einer sehr einfachen, langzeitstabilen, modulinternen Kühlflüssigkeitsverteilung anzugeben, wobei eine elektrisch leitfähige Kühlflüssigkeit - vorzugsweise Brauchwasser mit Frostschutzmittel - eingesetzt werden soll.

Diese Aufgabe wird in Verbindung mit den Merkmalen des Oberbegriffes erfindungsgemäß durch die im Kennzeichen des Anspruchs 1 angegebenen Merkmale gelöst.

Die mit der Erfindung erzielbaren Vorteile bestehen insbesondere darin, daß das vorgeschlagene Stromrichtermodul raum-, gewichts- und kostensparend ist, da der Stromrichtermodulrahmen neben der Trage- und Schutzfunktion auch die Kühlflüssigkeitsverteilungsfunktion zu allen flüssigkeitsgekühlten Leistungsbauelementen übernimmt und auf diese Weise Bauteile eingespart werden. Es tritt keine Alterung der zur Kühlflüssigkeitsführung notwendigen Bauelemente auf, was die Gefahr von Lecks mit nachfolgendem Totalausfall des Moduls ausschließt. Zusätzliche Verrohrungen über Schläuche sind nicht erforderlich. Das Modul ist insgesamt sehr langzeitstabil.

Über die relativ großen Flächen des Kühlrahmens kann zusätzlich Wärmeenergie durch modulinterne Luftumwälzung aufgenommen und über die Kühlflüssigkeit nach außen abgeführt werden. Die relativ großen Flächen des Kühlrahmens ermöglichen auch das direkte Anbringen von hydraulischen Kupplungen für den Kühlflüssigkeitsvorlauf und -rücklauf.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Figur 1: eine perspektivische Ansicht eines Stromrichtermodulrahmens mit integrierter Kühlflüssigkeitsverteilung,
- Figuren 2, 3: Schnitte durch einen Kühlrahmen.

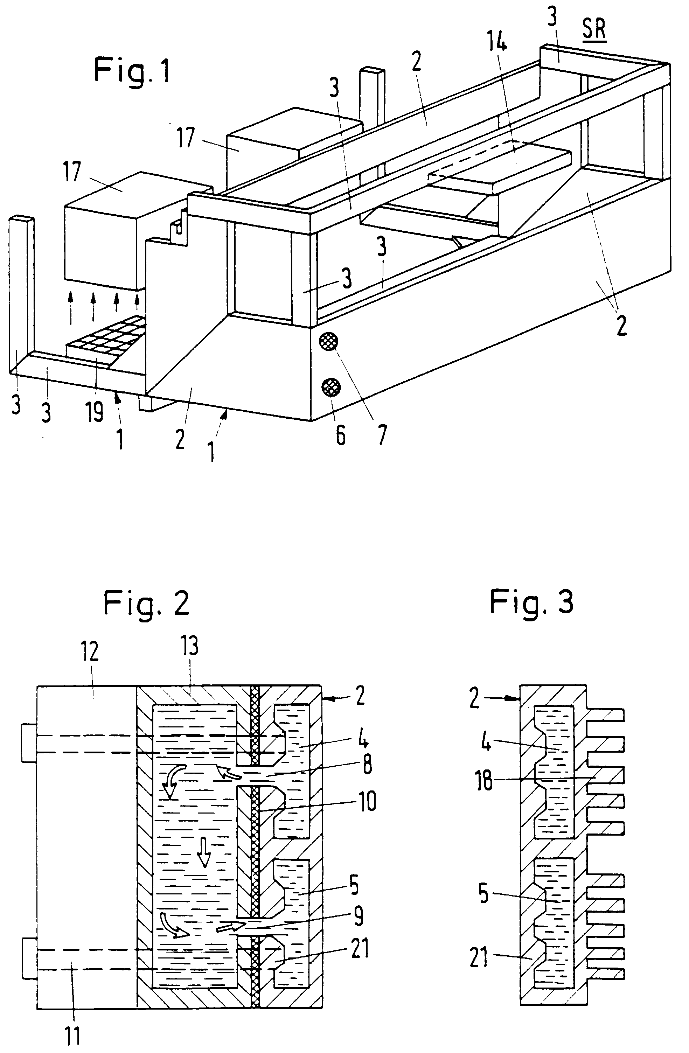

In Figur 1 ist eine perspektivische Ansicht eines Stromrichtermodulrahmens mit integrierter Kühlflüssigkeitsverteilung dargestellt. Es ist ein geschweißter, vorzugsweise aus einem Aluminiumprofil bestehender Stromrichtermodulrahmen 1 zu erkennen, der prinzipiell aus zwei Hauptkomponenten zusammengesetzt ist. Die erste Hauptkomponente wird durch einen Kühlrahmen 2 gebildet, der sowohl die Funktion eines tragenden Bauteils hat, als auch die gesamte Kühlflüssigkeitsverteilung innerhalb des Stromrichtermoduls SR bewältigt. Ferner stellt der Kühlrahmen einen wirksamen Schutz des Moduls dar. Die zweite Hauptkomponente wird durch einen Hilfsrahmen 3 gebildet, der lediglich eine tragende Funktion hat und nicht zur integrierten Kühlflüssigkeitsverteilung verwendet wird. Der Hilfsrahmen dient demnach in erster Linie zur Erhöhung der mechanischen Festigkeit des Stromrichtermodulrahmens 1 an denjenigen Rahmenabschnitten, an denen kein Kühlflüssigkeitsbedarf vorliegt.

Der Kühlrahmen 2 ist intern unterteilt in einen Kühlflüssigkeitsvorlaufkanal 4 und einen Kühlflüssigkeitsrücklaufkanal 5 (siehe Fig. 2, 3). Die Einspeisung des Kühlmittels in den Vorlaufkanal 4 erfolgt über eine Vorlauf-Steckkupplung 6, während für den Rücklauf der Kühlflüssigkeit eine Rücklauf-Steckkupplung 7 vorgesehen ist. Als Steckkupplungen 6, 7 dienen Schnellverschlußkupplungen, die in entsprechende Kupplungsteile eines das Modul tragenden Stromrichterschrankes eingreifen. Auf diese Weise ist ein schnelles Ein/Ausfahren des Moduls innerhalb des Stromrichterschrankes möglich, ohne vorher umständlich hydraulische Verbindungen zu demontieren.

Um die intensive Kühlung von Leistungsbauelementen 12 eines Stromrichtermoduls SR, wie Thyristoren, Dioden, Drosseln und Widerständen zu ermöglichen, ist der Kühlflüssigkeitsvorlaufkanal 4 mit Vorlauf-Anschlußöffnungen 8 und der Kühlflüssigkeitsrücklaufkanal 5 mit entsprechend vielen Rücklauf-Anschlußöffnungen 9 versehen (siehe Fig. 2, 3). An diese Anschlußöffnungen 8, 9 werden Kühlkörper 13 - beispielsweise Kühldosen zur Kühlung von Thyristoren - direkt angeschlossen, wobei die Montage über zwischengelegte, langzeitstabile Dichtungen 10 unter Einsatz von Schraubverbindungen 11 erfolgt. Alternativ zu direkt angeschlossenen Kühlkörpern 13 können auch Kühlschienen 14 mit den Anschlußöffnungen 8, 9 hydraulisch verbunden sein, wobei die Kühlschienen 14 entweder selbst Kühlkörperfunktion haben oder zu weiteren Kühlkörpern führen. Dabei können die Kühlschienen 14 beispielsweise einen rechteckigen Querschnitt und hydraulische Anschlüsse zum Vorlaufkanal 4 und zum Rücklaufkanal 5 aufweisen, wie in Figur 1 angedeutet. Davon abweichend kann eine derartige Kühlschiene auch einen kreisförmigen Querschnitt und lediglich einen hydraulischen Anschluß - entweder zum Vorlaufkanal 4 oder zum Rücklaufkanal 5 - aufweisen. Eine derartig ausgebildete Kühlschiene eignet sich beispielsweise zur Innenkühlung einer Drosselspule, wobei die wärmeproduzierende Wicklung der Drosselspule um die Kühlschiene greift.

Auch ist eine Ausgestaltung der Kühlschiene 14 möglich, deren erstes Ende mit dem Vorlaufkanal 4 und deren zweites Ende mit dem Rücklaufkanal 5 verbunden ist. Eine derartige Kühlschiene 14 kann tragende Funktion haben.

Zur Kühlung der Leistungsbauelemente 12 eines Stromrichtermoduls ergibt sich somit ein unter Einsatz einer Kühlmittelpumpe bewirkter Kühlflüssigkeitskreislauf über die Vorlauf-Steckkupplung 6, die Kühlflüssigkeitsvorlaufkanäle 4, die Vorlauf-Anschlußöffnungen 8, die Kühlkörper 13 und Kühlschienen 14, die Rücklauf-Anschlußöffnungen 9, die Kühlflüssigkeitsrücklaufkanäle 5 und die Rücklauf-Steckkupplung 7 zu einem externen Rückkühler, in dem die innerhalb des Moduls produzierte Wärmeenergie an die Außenatmosphäre abgegeben wird. Während der Heizperiode kann die erhitzte Kühlflüssigkeit auch vorteilhaft zur Heizung des Schienenfahrzeuges verwendet werden, indem die Kühlflüssigkeit beispielsweise in geeignete Heizregister geleitet und dort rückgekühlt wird. Die Kühlmittelpumpe, die in den meisten Fällen außerhalb des Stromrichtermoduls SR angeordnet ist, kann alternativ auch innerhalb des Kühlrahmens 2 des Stromrichtermoduls befindlich bzw. am Kühlrahmen angeflanscht sein.

Um eine Kühlung der thermisch gering belasteten und nicht direkt durch die Kühlflüssigkeit gekühlten Baukomponenten 17 des Stromrichtermoduls SR - wie beispielsweise Elektronik, Gate-Units und Stromschienen - sicherzustellen, werden diese unter Einsatz eines innerhalb des Moduls montierten Stromrichtermodul-Lüfters 19 luftgekühlt. Die durch die Verlustwärme der Baukomponenten 17 erhitzte Kühlluft wird über Rippen 18 des Kühlrahmens 2 rückgekühlt, wobei die Verlustwärme an die Kühlflüssigkeit abgegeben wird (siehe Figur 3). Auf diese Weise ergibt sich eine "indirekte Flüssigkeitskühlung" der Baukomponenten 17 durch Luftumwälzung innerhalb des Moduls. Da die Baukomponenten 17 vielfach mit erhöhtem elektrischem Potential behaftet sind, wäre eine direkte Flüssigkeitskühlung zumindest bei Einsatz einer elektrisch leitfähigen Kühlflüssigkeit mit zusätzlichen, wirtschaftlich nicht befriedigend lösbaren Problemen verbunden.

Da sowohl die Leistungsbauelemente 12 als auch die Baukomponenten 17 sehr effizient durch die vorstehend beschriebene Technik gekühlt werden, kann das Gehäuseinnere des Stromrichtermoduls SR unter Einsatz von Gehäusewänden hermetisch von der Außenatmosphäre abgeschlossen werden. Hierdurch werden vorteilhaft Staub, Feuchtigkeit, Aerosole, Metallabriebteilchen usw. von den empfindlichen Leistungsbauelementen 12 und Baukomponenten 17 ferngehalten.

In den Figuren 2 und 3 sind Schnitte durch einen Kühlrahmen dargestellt. Es sind jeweils die Querschnitte des Kühlflüssigkeitsvorlaufkanals 4 sowie des Kühlflüssigkeitsrücklaufkanals 5 des Kühlrahmens 2 zu erkennen. Die Profile sind druckfest gestaltet. Die Außenwandung der Kanäle ist mit Stegen 21 versehen, die beispielsweise zur Schraubbefestigung verwendet werden können, indem geeignete Gewindebohrungen eingeschnitten sind. Über diese Gewindebohrungen können die Schraubverbindungen 11 mit Kühlkörpern 13 oder Kühlschienen 14 sowie Steckkupplungen 6, 7 erfolgen. Üblicherweise notwendige Flanschplatten werden eingespart, wodurch sich Gewichts- und Kosteneinsparungen ergeben. Ferner können die Gehäusewände hierdurch einfach befestigt werden. Desweiteren ist beispielsweise die Montage von Gleitrollen zum erleichternden Einschub bzw. Ausfahren des Stromrichtermoduls innerhalb eines Stromrichterschrankes möglich. Es ist ein horizontaler oder vertikaler Einbau des Moduls durchführbar.

In Figur 3 sind die Rippen 18 des Kühlrahmens 2 zur Rückkühlung der durch den Stromrichtermodullüfter 19 im Gehäuseinnern des Stromrichtermoduls SR umgewälzten Luft zu erkennen. Über die Rippen 18 wird eine relativ große Oberfläche gebildet, die zur Wärmeübertragung im Sinne eines Luft/Flüssigkeitswärmetauschers geeignet ist. Falls eine Aufheizung der unmittelbar um das Stromrichtermodul befindlichen Luft zugelassen ist, können die Rippen 18 des Kühlrahmens 2 zusätzlich auch nach außen gerichtet sein, wodurch die Flüssigkeitskühlung durch Konvektion außerhalb des Stromrichtermoduls unterstützt wird.

## Patentansprüche

1. Flüssigkeitsgekühltes Stromrichtermodul mit Stromrichtermodulrahmen, wobei der Stromrichtermodulrahmen (1,2) zusätzlich zur Trage- und Schutzfunktion die modulinterne Kühlflüssigkeitsverteilung zu den Leistungsbauelementen (12) wahrnimmt und hierzu mit mindestens einem Kühlflüssigkeitskanal (4,5) versehen ist, wobei zur Kühlung der Leistungsbauelemente (12) jeweils Anschlußöffnungen (8,9) im Kanal vorgesehen sind, dadurch gekennzeichnet, daß Kühlkörper (13) und/oder Kühlschienen (14) über Schraubverbindungen (11) und zwischengelegte langzeitstabile Dichtungen (10) an die Anschlußöffnungen (8,9) montiert sind.

2. Stromrichtermodul nach Anspruch 1, dadurch gekennzeichnet, daß sowohl ein Kühlflüssigkeitsvorlauf- (4) als auch ein -rücklaufkanal (5) im Stromrichtermodulrahmen (1,2) integriert sind.

3. Stromrichtermodul nach Anspruch 1 und/oder 2, dadurch gekennzeichnet, daß der Stromrichtermodulrahmen (1,2) mit einer Vorlauf- (6) und einer Rücklauf-Steckkupplung (7) für den Kühlflüssigkeitsanschluß innerhalb eines Stromrichterschrankes versehen ist.

4. Stromrichtermodul nach wenigstens einem der Ansprüche 1 bis 3, dadurch gekennzeichnet, daß der Stromrichtermodulrahmen (1,2) für Schraubbefestigungen geeignete Stege (21) aufweist.

5. Stromrichtermodul nach wenigstens einem der Ansprüche 1 bis 4, dadurch gekennzeichnet, daß der Stromrichtermodulrahmen (1,2) zumindest auf seiner dem Modulinneren zugewandten Hauptfläche mit Rippen (18) versehen ist.

6. Stromrichtermodul nach wenigstens einem der Ansprüche 1 bis 5, dadurch gekennzeichnet, daß der Stromrichtermodulrahmen (1,2) zur Erhöhung der mechanischen Stabilität mit einem Hilfsrahmen (3) verbunden ist.

## Claims

1. Liquid-cooled rectifier module with rectifier module frame, the rectifier module frame (1, 2) performing not only the carrying and protection functions, but also the distribution of cooling liquid within the module to the power components (12) and, for this purpose, being provided with at least one cooling-liquid duct (4, 5), connection orifices (8, 9) being provided in each case in the duct for cooling the power components (12), characterized in that cooling bodies (13) and/or cooling rails (14) are mounted on the connection orifices (8, 9) via screw connections (11) and interposed gaskets (10) having long-term stability.

2. Rectifier module according to Claim 1, characterized in that both a cooling-liquid forward-flow duct (4) and a cooling-liquid return-flow duct (5) are integrated in the rectifier module frame (1, 2).

3. Rectifier module according to Claim 1 and/or 2, characterized in that the rectifier module frame (1, 2) is provided with a forward-flow plug coupling (6) and a return-flow plug coupling (7) for the connection of cooling liquid within a rectifier cabinet.

4. Rectifier module according to at least one of Claims 1 to 3, characterized in that the rectifier module frame (1, 2) has webs (21) suitable for screw fastenings.

5. Rectifier module according to at least one of Claims 1 to 4, characterized in that the rectifier module frame (1, 2) is provided with ribs (18) at least on its main surface facing the module interior.

6. Rectifier module according to at least one of Claims 1 to 5, characterized in that the rectifier module frame (1, 2) is connected to an auxiliary frame (3) for the purpose of increasing the mechanical stability.

## Revendications

1. Module convertisseur de courant refroidi par liquide comportant un socle de module convertisseur de courant, le socle (1, 2) de module convertisseur de courant assurant, en plus de sa fonction de support et de protection, la distribution du liquide de refroidissement à l'intérieur du module vers les composants de puissance (12) et étant pourvu à cet effet d'un moins un canal (4, 5) de liquide de refroidissement, des orifices de branchement (8, 9) étant prévus chaque fois dans le canal, pour le refroidissement des composants de puissance (12), caractérisé par le fait que des radiateurs (13) et/ou des blocs refroidisseurs (14) sont connectés aux orifices de branchement (8, 9) par l'intermédiaire des liaisons vissées (11) et des joints (10) stables dans le temps.

2. Module convertisseur de courant selon la revendication 1, caractérisé par le fait qu'un canal d'arrivée (4) de liquide de refroidissement et un canal de retour (5) de liquide de refroidissement sont intégrés dans le socle (1, 2) de module convertisseur de courant.

3. Module convertisseur de courant selon la revendication 1 et/ou 2, caractérisé par le fait que le socle (1, 2) de module convertisseur de courant est pourvu d'un raccord enfichable (6) d'arrivée et d'un raccord enfichable (7) de retour pour la connexion au circuit de fluide de refroidissement à l'intérieur d'une armoire de convertisseur de courant.

4. Module convertisseur de courant selon au moins une des revendications 1 à 3, caractérisé par le fait que le socle (1, 2) de module convertisseur de courant présente des nervures (21) adaptées pour des fixations par vis.

5. Module convertisseur de courant selon au moins une des revendications 1 à 4, caractérisé par le fait que le socle (1, 2) de module convertisseur de courant, au moins sur sa surface principale tournée vers l'intérieur du module, est pourvu d'ailettes (18).

6. Module convertisseur de courant selon au moins une des revendications 1 à 5, caractérisé par le fait que le socle (1, 2) de module convertisseur de courant est lié à un châssis auxiliaire (3) aux fins d'améliorer sa stabilité mécanique.
